# EUROPEAN PATENT APPLICATION

(11) **EP 4 718 958 A2**
(43) Date of publication of application: **01.04.2026**
(21) Application number: 25195776.7
(22) Date of filing: 13.08.2025
(51) Int. Cl.: H05K 7/14

(54) **POWER ELECTRONICS ENCLOSURES**

(30) Priority: 06.09.2024 US 202418826800
(71) Applicant: Schneider Electric USA, Inc., Andover, MA 01810 (US)
(72) Inventor: Richter, Jeff, Andover, MA (US); Scott, Colin, Andover, MA (US); Winter, Tannan Whidden, Fitchburg, MA (US); Bhattacharya, Subhadeep, Andover, MA (US); Venugopal, Arun, Andover, MA (US)
(74) Representative: Manitz Finsterwald Patent- und Rechtsanwaltspartnerschaft mbB

(57) **Abstract**

A system includes an enclosure defining an interior space enclosed by a wall of the enclosure. Power electronics are disposed within the interior space. The power electronics can include at least one inverter configured to invert direct current (DC) power to alternating power, at least one voltage converter for boosting voltage from a DC source up to electrical panel voltage, at least one rectifier configured to rectify alternating current (AC) power to DC power, and at least one voltage converter for reducing voltage from electrical panel voltage to a battery charging level. Wall mounting features can extend from the enclosure, configured for mounting the enclosure to a wall surface. It is also contemplated that hinge components can extend from the wall of the enclosure so the enclosure can be hingedly mounted to an electrical panel as a door of the electrical panel.

## Description

### BACKGROUND

### 1. Field

The present disclosure relates to power electronics, and more particularly to power electronics for use with electrical panels such as in residential applications.

### 2. Description of Related Art

Power electronics for residential use, i.e., for homes, small businesses, and the like, make it possible for a residence to be connected to a utility grid for alternating current (AC) power to convert between AC and direct current (DC), to convert between different voltages, and the like. Power electronics for applications such as electric vehicles (EV), back up batteries, solar panels, and the like can include inverters, rectifiers, and voltage converters. Such devices can be connected to a residential electrical panel which provides distribution to the various circuits of the residence as well as circuit protection such as breakers.

One problem with power electronics for residential applications is that they can add several boxes or panels in addition to the main electrical panel of a residence. This takes up space, and can complicate repair, upgrade, and replacement. A problem with packaging power electronics in an enclosure such as inside the main electrical panel is that typical electrical panels can potentially be used for up to and exceeding 50 years. Having to replace and rewire the whole electrical panel every time a residence owner has to replace the power electronics is the problem that has prevented more integration of power electronics with residential electrical panels.

The conventional techniques have been considered satisfactory for their intended purpose. However, there is an ever-present need for improved systems and methods for integrating power electronics for residential use. This disclosure provides a solution for this need.

### SUMMARY

A system includes an enclosure defining an interior space enclosed by a wall of the enclosure. Power electronics are disposed within the interior space. A connector extends from the power electronics, through the wall of the enclosure to an exterior space outside of the enclosure for connecting the power electronics to external components.

The power electronics can include a rectifier configured to convert electrical panel power to direct current (DC) power for charging DC batteries. The power electronics can include a voltage converter for converting electrical panel voltage to a different voltage for charging DC batteries. The power electronics can include an inverter configured to convert direct current (DC) power to alternating current for supplying power to an electrical panel from one or more DC sources such as solar panels, stationary energy storage systems (ESS), electric vehicle (EV) batteries, or the like. The power electronics can include a voltage converter for converting DC source voltage to electrical panel voltage for supplying power to an electrical panel. It is contemplated that the power electronics can include at least one inverter configured to invert direct current (DC) power to alternating power, at least one voltage converter for boosting voltage from a DC source up to electrical panel voltage, at least one rectifier configured to rectify alternating current (AC) power to DC power, and at least one voltage converter for reducing voltage from electrical panel voltage to a battery charging level. The power electronics can also include a transformer operatively connected to provide neutral during back up operations.

Wall mounting features can extend from the enclosure, configured for mounting the enclosure to a wall surface. It is also contemplated that first hinge components can extend from the wall of the enclosure. The first hinge components can be configured to be hingedly connected to second hinge components. The first hinge components can include respective hinge barrels configured to drop down over respective hinge pins for installation and to lift up off of the respective hinge pins for removal. The first hinge components can include respective hinge pins configured to drop down into respective hinge barrels for installation and to lift up out of the respective hinge barrels for removal. The connector can include a wire harness with a plug at the end thereof for electrically connecting wires between the power electronics and the external components.

A system includes an electrical panel configured to distribute power among a plurality of load circuits. An enclosure defines an interior space enclosed by a wall of the enclosure. Power electronics are disposed within the interior space. A connector extends from the power electronics, through the wall of the enclosure to an exterior space outside of the enclosure. The connector electrically connects the power electronics to an interior of the electrical panel.

The interior of the electrical panel can include respective circuit breakers operatively connected for protecting the load circuits. An electric vehicle (EV) dispenser can be operatively connected to the electrical panel and to the power electronics for charging an EV and/or powering the circuits from the EV. Each of the enclosure and the electrical panel can be configured to be mounted to a wall surface. The electrical panel can be configured to be mounted to a wall surface, and the enclosure can be configured to be hingedly mounted to the electrical panel as a door of the electrical panel.

The power electronics can include at least one inverter configured to invert direct current (DC) power to alternating power, at least one voltage converter for boosting voltage from a DC source up to electrical panel voltage, at least one rectifier configured to rectify alternating current (AC) power to DC power, and at least one voltage converter for reducing voltage from electrical panel voltage to a battery charging level.

First hinge components can extend from the wall of the enclosure. The first hinge components can include respective hinge barrels configured to be seated over respective hinge pins of the electrical panel. First hinge components can extend from the wall of the enclosure. The first hinge components can include respective hinge pins configured to drop down into respective hinge barrels for installation and to lift up out of the respective hinge barrels for removal. The connector can include a wire harness with a plug at the end thereof for plugging into a respective socket of the panel for electrically connecting wires between the power electronics and the external components.

These and other features of the systems and methods of the subject disclosure will become more readily apparent to those skilled in the art from the following detailed description of the preferred embodiments taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below with reference to certain figures, wherein:
Fig. 1 is a schematic perspective view of an embodiment of a system constructed in accordance with the present disclosure, showing the enclosure configured as a door hingedly mounted to the electrical panel with the door open;
Fig. 2 is a schematic perspective view of the system of Fig. 1, showing the door in the closed position;
Fig. 3 is a schematic exploded perspective view of the system of Fig. 1, showing the door separated from the electrical panel;
Fig. 4 is a schematic elevation view of the system of Fig. 1, showing the meter and the electric vehicle (EV) dispenser connected to the electrical panel;
Fig. 5 is a schematic view of a portion of the system of Fig. 1, showing the power electronics inside the enclosure; and
Fig. 6 is a schematic view of the system of Fig. 1, showing the enclosure of the power electronics configured for mounting to a wall surface rather than as a door.

### DETAILED DESCRIPTION OF THE PREFERRED EMBODIMENTS

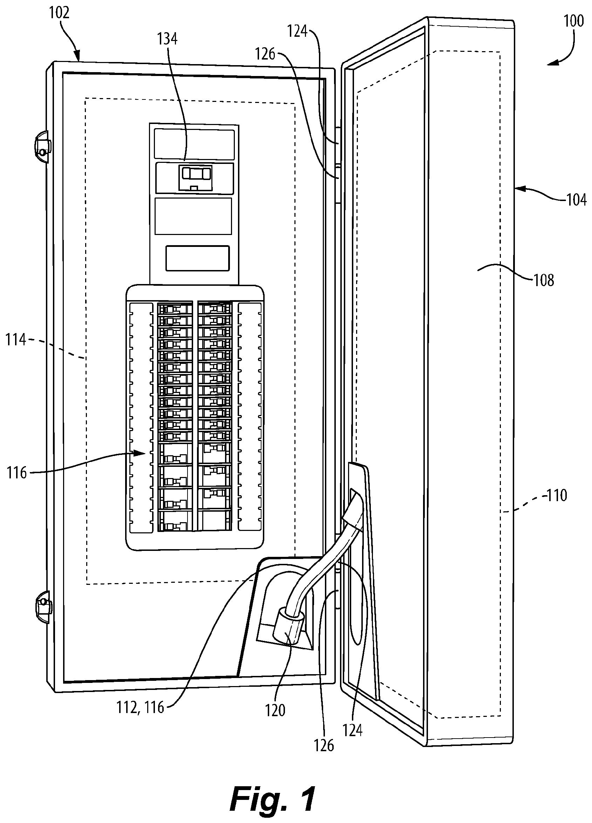

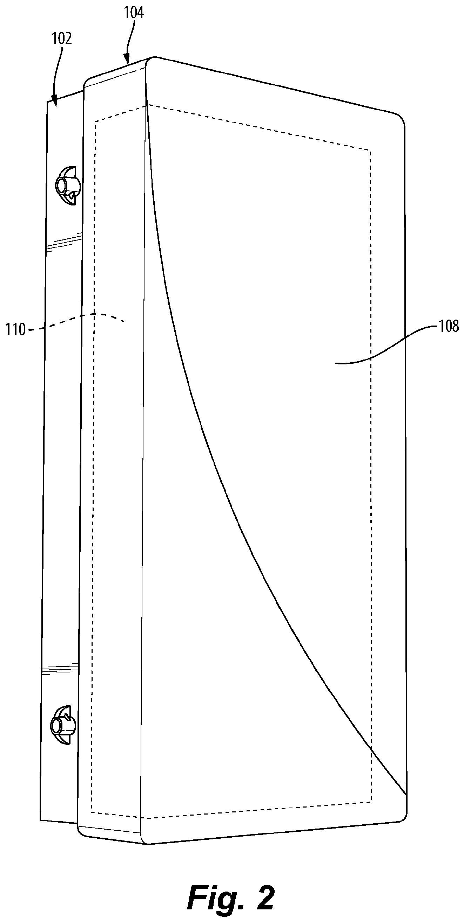

Reference will now be made to the drawings wherein like reference numerals identify similar structural features or aspects of the subject disclosure. For purposes of explanation and illustration, and not limitation, a partial view of an embodiment of a system in accordance with the disclosure is shown in Fig. 1 and is designated generally by reference character 100. Other embodiments of systems in accordance with the disclosure, or aspects thereof, are provided in Figs. 2-6, as will be described. The systems and methods described herein can be used to facilitate installation, repair, and replacement of power electronics for connecting to residential electrical panels.

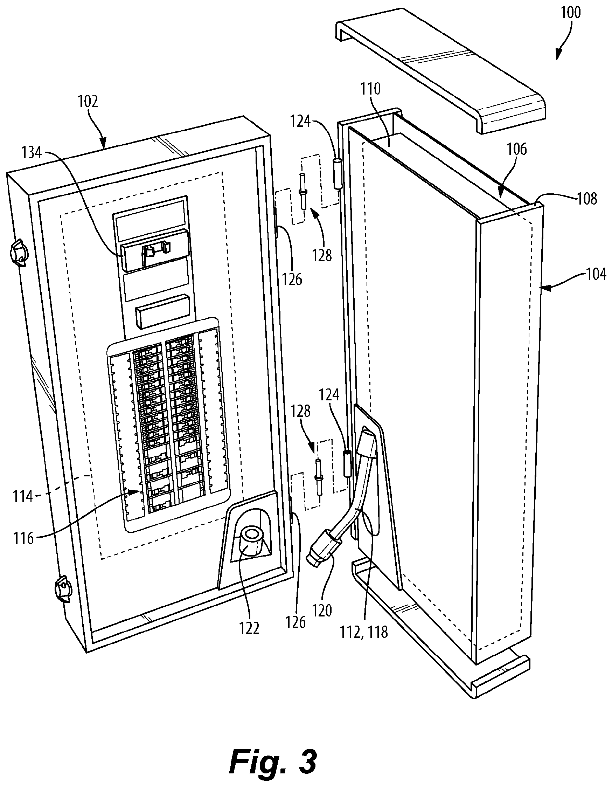

The system 100 includes an electrical panel 102 configured to distribute power among a plurality of load circuits. The electrical panel 102 is configured to be mounted to a wall surface. An enclosure 104 defines an interior space 106 (labeled in Fig. 3) enclosed by a wall 108 of the enclosure 104. Power electronics 110 are disposed within the interior space 106 (labeled in Fig. 3). A connector 112 extends from the power electronics 110, through the wall 108 of the enclosure to an exterior space outside of the enclosure 104. The connector 112 electrically connects the power electronics 110 to an interior 114 of the electrical panel 102. The interior 114 of the electrical panel 102 includes respective circuit breakers 116 operatively connected to the interior 114 for protecting the load circuits, e.g., the various circuits distributed throughout a residence for lighting, outlets, furnace, ovens, ranges, washers/driers, air conditioning, and the like. The enclosure 104 is configured to be a door for the electrical panel 102, shown in the open position in Fig. 1, and in the closed position in Fig. 2.

With reference now to Fig. 3, the door or enclosure 104 can be disconnected and removed from the electrical panel 102 without disconnecting the individual circuits of the circuit breakers 116, and without even opening the electrical panel 102 itself. The connector 112 includes a wire harness 118 with a plug 120 at the end thereof for plugging into the respective socket 122 of the panel for electrically connecting wires between the power electronics 110 and the external components, e.g., through the electrical panel 102.

Hinge components 124 extend from the wall of the enclosure, e.g., along an edge thereof. The hinge components 124 are configured to be hingedly connected to corresponding hinge components 126 of the electrical panel 102. The hinge components 124, 126 include respective hinge barrels configured to fit over respective hinge pins 128 for installation. This allows the hinge components 124 and pins 128 to drop down onto/into the hinge components 126 for installation, and to lift up off of the hinge components 126 for removal. The hinge pins 128 can be separate components or can be permanently affixed to either the hinge components 124 or to the hinge components 126. In this manner, the hinges connecting the enclosure 104 to the electrical panel 102 allow for ease of installation and removal. Although depicted in Figs. 1-3 with the hinges on the right hand side of the electrical panel 102, those skilled in the art having had the benefit of this disclosure will readily appreciate that any suitable hinge arrangement can be used, e.g. the hinges can be on the left hand side, the top side, or the bottom side as oriented in Figs. 1-3 without departing from the scope of this disclosure. Moreover, while shown with a single door, those skilled in the art having had the benefit of this disclosure will readily appreciate that multiple doors can be used, e.g. where different parts of the power electronics 110 are mounted in different doors hinged to the electrical panel 102.

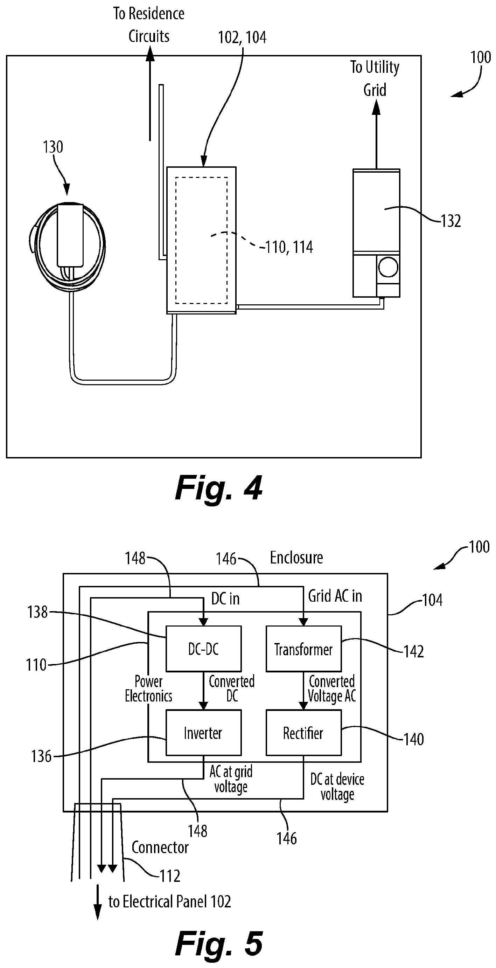

With reference now to Fig. 4, the system 100 can include an electric vehicle (EV) dispenser 130 that is operatively connected to the electrical panel 102 and power electronics 110 for charging an EV and/or powering the circuits from the EV, e.g. to utilize the EV battery as a backup, to shift peak usage for improved utility rates, or the like. A utility meter 132 is operatively connected to the electrical panel 102, with a built-in transfer switch 134 (labeled in Figs. 1 and 3), configured to disconnect the interior 114 and all of its circuits from the utility meter 132. This can allow for the electrical panel 102 to supply power to the circuits of the residence from battery storage or generation sources such as solar panels, with the electrical panel 102 isolated or islanded from the utility grid.

With reference now to Fig. 5, the power electronics 110 include components for converting diverse types of power, including different current types (AC or DC), and different voltage levels. These components can allow for bidirectional charging to/from batteries such as EV batteries. For DC to AC conversion, the power electronics 110 can include at least one inverter 136 configured to invert direct current (DC) power to alternating current (AC) power for supplying AC power to an electrical panel from one or more DC sources. DC sources can include generation equipment such as solar panels, generators, or the like, as well as back up batteries, stationary energy storage systems (ESS), EV batteries, or the like. The power electronics 110 can also include at least one DC-DC voltage converter 138 for converting DC source voltage to electrical panel voltage for supplying power to the electrical panel 102 for supplying loads in the circuits of the electrical panel 102, or for supplying power from the electrical panel 102 to the utility grid. The DC-DC voltage converter 138 can be a DC-DC converter for boosting or reducing voltage as needed, e.g., for boosting voltage from a DC source such as solar panels, back up batteries, or EV batteries up to electrical panel voltage.

For AC to DC conversion, the power electronics can include at least one rectifier 140 configured to rectify AC power, e.g., from the utility grid via the electrical panel 102, into DC power. At least one voltage converter 142, such as a transformer, can be included for reducing or otherwise converting voltage from electrical panel voltage to a battery charging level for charging DC batteries or powering other DC loads. In the case of a transformer, it is also contemplated that the transformer can be operatively connected to provide neutral during back up operations.

The configuration shown in Fig. 5 includes one AC-DC conversion pathway or channel 146, and one DC-AC conversion pathway or channel 148 and can thus perform bidirectional charging. For example, a battery of an EV or backup/storage battery connected to the power electronics 110 can either charge the electrical panel 102 or be charged by the electrical panel 102 using the power electronics 110. Those skilled in the art will readily appreciate that any suitable number of different AC-DC pathways or channels can be included for providing various DC voltages, as well as any suitable number of different DC-AC pathways or channels, e.g. for providing various voltages of AC power from various DC voltages, without departing from the scope of this disclosure.

The AC-DC conversion pathway or channel 146 accepts AC power from the electrical panel 102, e.g. through the connector 112 into the voltage converter 142, e.g. a transformer, which in many applications will reduce voltage from the grid or panel voltage down to a suitable DC voltage for a given DC load, such as charging an EV battery. The output of the voltage converter 142 is converted voltage AC power, e.g., at a reduced voltage, which is supplied to the rectifier 140. The rectifier converts the converted voltage AC into DC power at the correct voltage level for output to the DC device or battery through the connector 112.

The DC-AC conversion pathway or channel 148 accepts DC power from the electrical panel, e.g. through the connector 112 into the DC-DC voltage converter 138, e.g. a boost converter, which in many applications will increase voltage from a DC source such as solar panels or batteries to a suitable AC voltage, e.g. for use by the circuits of the electrical panel 102. The output of the DC-DC voltage converter 138 is converted DC power, which is supplied to the inverter 136. The inverter 136 converts the converted DC power into AC power at the desired voltage, e.g., grid or panel voltage. This can be supplied from the power electronics 110 to the electrical panel 102, e.g., through the connector 112. Although shown as s four separate components, the DC-DC voltage converter 138, the inverter 136, the voltage converter 142, and the rectifier 140 can be combined or separate individual components. For example, the power electronics 110 can include a single component that accepts DC input and outputs AC voltage at the desired output voltage, e.g., with a combined DC-DC converter/inverter device. It is also contemplated that the power electronics 110 need not be bidirectional, and may only include a single power electronics component, e.g. a single inverter, a single rectifier, or a single voltage converter.

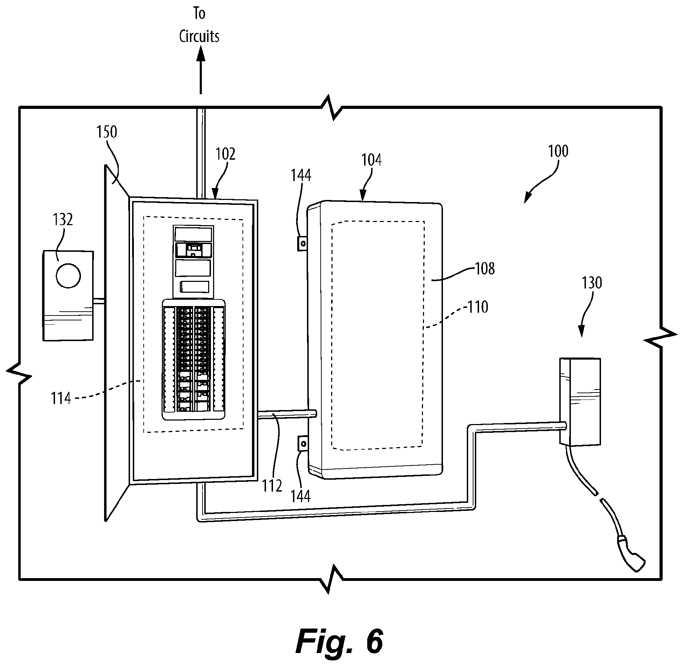

With reference now to Fig. 6, it is also contemplated that in addition to or in lieu of the hinge components 124 numbered in Figs. 1 and 3, wall mounting features 144 can be included, extending from the wall 108 of the enclosure 104. The wall mounting features 144 are configured for mounting the enclosure 104 and the electrical panel 102 to a wall surface, e.g., together with the electrical panel 102, the meter 132, and the EV dispenser 130, as shown in Fig. 6. The electrical panel 102 can in this configuration include a panel door 150 that is separate from the enclosure 104.

The present disclosure provides for a home or residential electrical panel packaged together with power conversion hardware. All of the power conversion equipment can be on the door of the panel, or in an enclosure mounted to a wall surface, e.g., near the panel. This can provide ease of installation and ease of servicing. Typically, home panels last over 50 years and the useful life of various power electronics may be much shorter. By keeping the power conversion equipment on the door or a separate enclosure, a homeowner can keep upgrading the panel with new doors or separate enclosures without having to change the main panel every time. Also, in the event of a failure, the door or enclosure alone can be replaced without disturbing the home or residential loads.

The power electronics can be packaged in an enclosure as disclosed herein to reduce heat dissipation, weight, dimension, and heat generation while still maintaining a National Electrical Manufacturers Association (NEMA) NEMA 4X rating for the door. The hinge system as disclosed herein can allow for easy mounting of the door and will be able to bear the weight of the door. A cable management system as disclosed herein can help to ensure the cables which run from the door to the panel are easy to manage and do not get pinched and allow for easy opening of the door. The cable management system can ensure that there is no pinching of the cables when the door is being closed which could otherwise cause short circuits. The power electronics can be packaged to help reduce the door dimensions and weight and ensure the door is not too heavy for the hinge and at the same time meet the functional requirements. Reducing the dimensions of the door or separate enclosure helps ensure the panel and power electronics do not take too much space on the wall surface.

Systems and methods as disclosed herein can provide potential benefits including the following. They can allows a central controller concept for complicated systems, reducing system control and communication complexity. They can reduce installation time as they provide for movable, and installable parts. They can reduce system downtime. They provide for the power electronic converter to be on the door or to be installed separately. It is contemplated that the panel can also be put on the door. Systems and methods as disclosed herein can allow a user to use a smart component in two different places as they just need to remove the door. Systems and methods as disclosed herein can also use the multiple-door concept, e.g., where one part of the door is common across the applications (such as an inverter), and the other door can be removed if needed. Systems and methods as disclosed herein also allows for better thermal management as either the door or the panel can have active thermal management (e.g., a fan or liquid cooling system). The panel can be configured for flush mount or surface mount, providing flexibility to the end user.

The methods and systems of the present disclosure, as described above and shown in the drawings, provide for facilitated installation, repair, and replacement of power electronics for connecting to residential electrical panels. While the apparatus and methods of the subject disclosure have been shown and described with reference to preferred embodiments, those skilled in the art will readily appreciate that changes and/or modifications may be made thereto without departing from the scope of the subject disclosure.

## Claims

1. A system comprising:
an enclosure defining an interior space enclosed by a wall of the enclosure;
power electronics disposed within the interior space; and
a connector extending from the power electronics, through the wall of the enclosure to an exterior space outside of the enclosure for connecting the power electronics to external components.

2. The system as recited in claim 1, wherein the power electronics include a rectifier configured to convert electrical panel power to direct current (DC) power for charging DC batteries,
wherein the power electronics in particular include a voltage converter for converting electrical panel voltage to a different voltage for charging DC batteries.

3. The system as recited in claim 1 or 2, wherein the power electronics include an inverter configured to convert direct current (DC) power to alternating current for supplying power to an electrical panel from one or more DC sources,
wherein the power electronics in particular include a voltage converter for converting DC source voltage to electrical panel voltage for supplying power to an electrical panel.

4. The system as recited in any one of the preceding claims, wherein the power electronics include:
at least one inverter configured to invert direct current (DC) power to alternating power;
at least one voltage converter for boosting voltage from a DC source up to electrical panel voltage;
at least one rectifier configured to rectify alternating current (AC) power to DC power; and
at least one voltage converter for reducing voltage from electrical panel voltage to a battery charging level.

5. The system as recited in any one of the preceding claims, further comprising wall mounting features extending from the enclosure, configured for mounting the enclosure to a wall surface.

6. The system as recited in any one of the preceding claims, further comprising first hinge components extending from the wall of the enclosure, wherein the first hinge components are configured to be hingedly connected to second hinge components,
wherein the first hinge components in particular include respective hinge barrels configured to drop down over respective hinge pins for installation and to lift up off of the respective hinge pins for removal.

7. The system as recited in claim 6, wherein the first hinge components include respective hinge pins configured to drop down into respective hinge barrels for installation and to lift up out of the respective hinge barrels for removal.

8. The system as recited in any one of the preceding claims, wherein the connector includes a wire harness with a plug at the end thereof for electrically connecting wires between the power electronics and the external components.

9. A system comprising:
an electrical panel configured to distribute power among a plurality of load circuits;
an enclosure defining an interior space enclosed by a wall of the enclosure;
power electronics disposed within the interior space; and
a connector extending from the power electronics, through the wall of the enclosure to an exterior space outside of the enclosure, wherein the connector electrically connects the power electronics to an interior of the electrical panel,
wherein the interior of the electrical panel in particular includes respective circuit breakers operatively connected for protecting the load circuits.

10. The system as recited in claim 9, wherein the power electronics include a transformer operatively connected to provide neutral during back up operations.

11. The system as recited in claim 9 or 10, wherein each of the enclosure and the electrical panel are configured to be mounted to a wall surface.

12. The system as recited in any one of claims 9 - 11, wherein the electrical panel is configured to be mounted to a wall surface, and wherein the enclosure is configured to be hingedly mounted to the electrical panel as a door of the electrical panel,
wherein the power electronics in particular include:
at least one inverter configured to invert direct current (DC) power to alternating power;
at least one voltage converter for boosting voltage from a DC source up to electrical panel voltage;
at least one rectifier configured to rectify alternating current (AC) power to DC power; and
at least one voltage converter for reducing voltage from electrical panel voltage to a battery charging level.

13. The system as recited in claim 12, further comprising first hinge components extending from the wall of the enclosure, wherein the first hinge components include respective hinge barrels configured to be seated over respective hinge pins of the electrical panel.

14. The system as recited in claim 12 or 13, further comprising first hinge components extending from the wall of the enclosure, wherein the first hinge components include respective hinge pins configured to drop down into respective hinge barrels for installation and to lift up out of the respective hinge barrels for removal.

15. The system as recited in any one of claims 9 - 14, wherein the connector includes a wire harness with a plug at the end thereof for plugging into a respective socket of the panel for electrically connecting wires between the power electronics and the external components.
